# EUROPEAN PATENT APPLICATION

(11) **EP 4 621 424 A1**
(43) Date of publication of application: **24.09.2025**
(21) Application number: 25164958.8
(22) Date of filing: 20.03.2025
(51) Int. Cl.: G01R 31/317, G01R 31/3185, G01R 31/3187, G06F 11/27

(54) **METHOD AND APPARATUS FOR STARTING INTERFACE TEST**

(30) Priority: 22.03.2024 CN 202410343056
(71) Applicant: Huawei Technologies Co., Ltd., Shenzhen, Guangdong 518129 (CN)
(72) Inventor: XU, Tuanhui, Shenzhen, 518129 (CN); PIAO, Yinghun, Shenzhen, 518129 (CN); CUI, Changming, Shenzhen, 518129 (CN)
(74) Representative: Epping - Hermann - Fischer

(57) **Abstract**

Embodiments of this application provide a method and an apparatus for starting an interface test, and relate to the field of electronic technologies, to synchronously start the interface test at two ends. The method includes: A first chiplet sends a first preamble to a second chiplet through at least one first interface, where the first preamble indicates that the first chiplet is to start a first BIST test, the first chiplet is interconnected to the second chiplet through a plurality of interfaces, and the plurality of interfaces include the at least one first interface; and when the first preamble is completely sent, the first chiplet starts the first BIST test. The second chiplet receives the first preamble from the first chiplet, and detects the first preamble; and when the second chiplet successfully detects the first preamble, the second chiplet starts the first BIST test.

## Description

### TECHNICAL FIELD

This application relates to the field of electronic technologies, and in particular, to a method and an apparatus for starting an interface test.

### BACKGROUND

A chiplet (chiplet) is a small chip that has a specific function and can be combined and integrated. The small chip may also be referred to as a die (die), a crystal grain, or a wafer. A chiplet technology is to integrate a plurality of small chips by using an advanced packaging technology to form a system-level chip. The chiplet technology can achieve low costs and a high yield while improving performance of the system-level chip.

In the chip based on the chiplet technology, there are usually thousands of interconnected interfaces, and the interface may be used to transmit high-speed data. At present, if a process defect is introduced to an interface of a chiplet during production and manufacturing, a function of the chiplet may be affected, and then a yield rate of an entire packaged chip is affected. Further, if the process defect is not found in a chip test process, a defective chip is used in a product, causing a greater loss. Therefore, an interface test is especially important in terms of test, yield, and costs.

### SUMMARY

This application provides a method and an apparatus for starting an interface test, to implement synchronous starting of the interface test.

To achieve the foregoing objectives, the following technical solutions are used in embodiments of this application.

According to a first aspect, a method for starting an interface test is provided. The method includes: A first chiplet sends a first preamble to a second chiplet through at least one first interface, where the first preamble may include a plurality of pieces of data of specific lengths, there is different data in the plurality of pieces of data, and the first preamble indicates that the first chiplet is to start a first BIST test, the first chiplet is interconnected to the second chiplet through a plurality of interfaces, the plurality of interfaces include the at least one first interface, and the at least one first interface may be any one of the plurality of interfaces. When the first preamble is completely sent, the first chiplet starts the first BIST test, for example, starts the first BIST test at a sending end moment of the first preamble. Starting the first BIST test may be sending test data.

In the foregoing technical solution, the first chiplet may send the preamble to the second chiplet through the at least one of the plurality of interconnected interfaces, and start the first BIST test after the preamble is completely sent. The first preamble indicates that the first chiplet is to start the first BIST test, so that a receive end starts the first BIST test when receiving and successfully detecting the first preamble, thereby implementing synchronous starting of the first chiplet and the second chiplet, and ensuring validity of the BIST test. In addition, the method does not depend on synchronization circuits and key I/Os of functional modules in the first chiplet and the second chiplet, so that the method is more universal.

In a possible implementation of the first aspect, the at least one first interface includes at least two first interfaces, and that a first chiplet sends a first preamble to a second chiplet through at least one first interface includes: The first chiplet sends the first preamble to the second chiplet through each of the at least two first interfaces. First preambles sent through different first interfaces may be the same or different. In the foregoing possible implementation, the first chiplet sends the first preamble through each first interface of the at least two first interfaces. In this way, as long as the second chiplet successfully detects a first preamble corresponding to one second interface, it indicates that the first preamble is successfully detected. Therefore, a success rate of synchronous starting of the first chiplet and the second chiplet can be improved, and impact of an interface fault on synchronous starting of the interface test can be effectively reduced.

In a possible implementation of the first aspect, the method further includes: The first chiplet receives a second preamble from the second chiplet through at least one second interface, and detects the second preamble, where the second preamble indicates that the second chiplet is to start a second BIST test; and when the first chiplet successfully detects the second preamble, the first chiplet starts the second BIST test. In the foregoing possible implementation, after the first chiplet is used as a transmit end to complete the test, the first chiplet may be used as the receive end to receive and detect the second BIST test, and start the second BIST test when the second preamble is successfully detected, so that the first chiplet and the second chiplet can be synchronously started during both a forward test and a reverse test.

In a possible implementation of the first aspect, the at least one second interface includes at least two second interfaces, and that the first chiplet receives a second preamble from the second chiplet through at least one second interface includes: The first chiplet receives the second preamble from the second chiplet through each of the at least two second interfaces. In the foregoing possible implementation, the second chiplet receives the second preamble through each of the at least two second interfaces. In this way, a probability that the first chiplet successfully receives the first preamble can be increased.

In a possible implementation of the first aspect, for a second preamble corresponding to any one of the at least one second interface, the method further includes: The first chiplet detects whether the second preamble is consistent with a comparison preamble, where when the second preamble is consistent with the comparison preamble, it indicates that the second preamble is successfully detected. In the foregoing possible implementation, as long as the first chiplet successfully detects a first preamble corresponding to one second interface, it indicates that the first preamble is successfully detected. Therefore, a success rate of synchronous starting of the first chiplet and the second chiplet can be improved, and impact of an interface fault on synchronous starting of the interface test can be effectively reduced.

In a possible implementation of the first aspect, the method is applied to a chip package including a plurality of chiplets, where the plurality of chiplets are interconnected and packaged by using a chiplet technology, and the plurality of chiplets include the first chiplet and the second chiplet. In the foregoing possible implementation, synchronous starting of the first chiplet and the second chiplet in the chip package can be implemented, thereby ensuring validity of the BIST test. In addition, the method does not depend on synchronization circuits and key I/Os of functional modules in the first chiplet and the second chiplet, so that the method is more universal.

In a possible implementation of the first aspect, the first preamble or the second preamble includes a plurality of pieces of data of specific lengths, and there is different data in the plurality of pieces of data. Optionally, the first preamble or the second preamble is an interleaved code. In the foregoing possible implementation, a probability of successfully detecting the first preamble or the second preamble can be increased.

In a possible implementation of the first aspect, at least two interfaces between which an interface distance is greater than a preset distance exist in the at least one first interface or the at least one second interface. In the foregoing possible implementation, interfaces between which an interface distance is greater than the preset distance is selected to send the preamble, so that impact of an interface fault on synchronous starting of the interface test can be effectively reduced.

According to a second aspect, a method for starting an interface test is provided. The method includes: A second chiplet receives a first preamble from a first chiplet through at least one first interface, and detects the first preamble, where the first preamble indicates that the first chiplet is to start a first BIST test, the second chiplet is interconnected to the first chiplet through a plurality of interfaces, and the plurality of interfaces include the at least one first interface; and when the second chiplet successfully detects the first preamble, the second chiplet starts the first BIST test.

In a possible implementation of the second aspect, the at least one first interface includes at least two first interfaces, and that a second chiplet receives a first preamble from a first chiplet through at least one first interface includes: The second chiplet receives the first preamble from the first chiplet through each of the at least two first interfaces.

In a possible implementation of the second aspect, for a first preamble corresponding to any one of the at least one first interface, that the second chiplet detects the first preamble includes: The second chiplet detects whether the first preamble is consistent with a comparison preamble, where when the first preamble is consistent with the comparison preamble, it indicates that the first preamble is successfully detected.

In a possible implementation of the second aspect, the method further includes: The second chiplet sends a second preamble to the first chiplet through at least one second interface, where the second preamble indicates that the second chiplet is to start a second BIST test.

When the second preamble is completely sent, the second chiplet starts the second BIST test.

In a possible implementation of the second aspect, the at least one second interface includes at least two second interfaces, and the second chiplet sends a second preamble to the first chiplet through at least one second interface includes: The second chiplet sends the second preamble to the first chiplet through each of the at least two second interfaces.

In a possible implementation of the second aspect, the method is applied to a chip package including a plurality of chiplets, where the plurality of chiplets are interconnected and packaged by using a chiplet technology, and the plurality of chiplets include the first chiplet and the second chiplet.

In a possible implementation of the second aspect, the first preamble or the second preamble includes a plurality of pieces of data of specific lengths, and there is different data in the plurality of pieces of data.

In a possible implementation of the second aspect, at least two interfaces between which an interface distance is greater than a preset distance exist in the at least one first interface or the at least one second interface.

According to a third aspect, an apparatus for starting an interface test is provided. The apparatus may implement a function performed by the first chiplet in the foregoing method. The function may be implemented by hardware, or may be implemented by hardware by executing corresponding software. The hardware or software includes one or more modules corresponding to the foregoing function.

In a possible implementation of the third aspect, the apparatus includes a sending unit, a starting unit, a receiving unit, and a detection circuit. The detection circuit and the starting unit are configured to support the apparatus in performing a corresponding function in the foregoing method. The sending unit and the receiving unit are configured to support the apparatus in communicating with a second chiplet.

According to a fourth aspect, an apparatus for starting an interface test is provided. The apparatus may implement a function performed by a second chiplet in the foregoing method. The function may be implemented by hardware, or may be implemented by hardware by executing corresponding software. The hardware or software includes one or more modules corresponding to the foregoing function.

In a possible implementation of the fourth aspect, the apparatus includes a receiving unit, a detection circuit, a starting unit, and a sending unit. The detection circuit and the starting unit are configured to support the apparatus in performing a corresponding function in the foregoing method. The sending unit and the receiving unit are configured to support the apparatus in communicating with the second chiplet.

According to a fifth aspect, an apparatus for starting an interface test is provided. The apparatus includes a processor and a communication interface, and the processor and the communication interface are configured to support the apparatus in performing the method provided in any one of the first aspect or the possible implementations of the first aspect.

According to a sixth aspect, an apparatus for starting an interface test is provided. The apparatus includes a processor and a communication interface, and the processor and the communication interface are configured to support the apparatus in performing the method provided in any one of the second aspect or the possible implementations of the second aspect.

According to still another aspect of this application, a communication apparatus is provided. The communication apparatus includes a first chiplet and a second chiplet, the first chiplet includes the apparatus provided in the third aspect, any one of the possible implementations of the third aspect, or the fifth aspect, and the first chiplet is configured to perform the method provided in the first aspect or any one of the possible implementations of the first aspect. The second chiplet includes the apparatus provided in the fourth aspect, any one of the possible implementations of the fourth aspect, or the sixth aspect, and the second chiplet is configured to perform the method provided in the second aspect or any one of the possible implementations of the second aspect.

According to still another aspect of this application, a computer-readable storage medium is provided. The computer-readable storage medium stores a computer program or instructions. When the computer program or the instructions are run, the method according to any one of the first aspect or the possible implementations of the first aspect is implemented.

According to still another aspect of this application, a computer-readable storage medium is provided. The computer-readable storage medium stores a computer program or instructions. When the computer program or the instructions are run, the method according to any one of the second aspect or the possible implementations of the second aspect is implemented.

According to still another aspect of this application, a computer program product is provided. The computer program product includes a computer program (which may also be referred to as code or instructions). When the computer program is run, a computer is enabled to perform the method provided in any one of the first aspect or the possible implementations of the first aspect.

According to still another aspect of this application, a computer program product is provided. The computer program product includes a computer program (which may also be referred to as code or instructions). When the computer program is run, a computer is enabled to perform the method provided in any one of the second aspect or the possible implementations of the second aspect.

It may be understood that for beneficial effect of other aspects except any one of the first aspect and the possible implementations of the first aspect, refer to the beneficial effect of any one of the first aspect and the possible implementations of the first aspect. Details are not described herein again.

### BRIEF DESCRIPTION OF DRAWINGS

FIG. 1 is a diagram of a structure of a communication apparatus according to an embodiment of this application;
FIG. 2 is a diagram of a structure of a chiplet according to an embodiment of this application;
FIG. 3 is a diagram of distribution of a plurality of interfaces of a chiplet according to an embodiment of this application;
FIG. 4 is a schematic flowchart of a method for starting an interface test according to an embodiment of this application;
FIG. 5 is a diagram of structures of a first chiplet and a second chiplet according to an embodiment of this application;
FIG. 6 is a schematic flowchart of another method for starting an interface test according to an embodiment of this application;
FIG. 7 is a flowchart of starting an interface test according to an embodiment of this application;
FIG. 8 is a diagram of a structure of a first chiplet according to an embodiment of this application;
FIG. 9 is a diagram of a structure of another first chiplet according to an embodiment of this application;
FIG. 10 is a diagram of a structure of a second chiplet according to an embodiment of this application; and
FIG. 11 is a diagram of a structure of another second chiplet according to an embodiment of this application.

### DESCRIPTION OF EMBODIMENTS

The making and use of embodiments are discussed in detail below. It should be appreciated, however, that many applicable inventive concepts provided in this application may be implemented in a plurality of specific environments. The specific embodiments discussed are merely illustrative of specific ways to implement and use this application and this technology, and do not limit the scope of this application.

Unless otherwise defined, all technical terms used herein have same meanings as those commonly known to a person of ordinary skill in the art.

The circuits or other components may be described as or referred to as "configured to" perform one or more tasks. In this case, the term "configured to" is used for implying a structure by indicating that a circuit/component includes a structure (for example, a circuit system) that performs one or more tasks during operation. Therefore, even when a specified circuit/component is currently not operable (for example, not opened), the circuit/component may also be referred to as being configured to perform the task. Circuits/components used in conjunction with the "configured to" phrase include hardware, for example, a circuit for performing an operation.

The following describes the technical solutions in embodiments of this application with reference to the accompanying drawings in embodiments of this application. In this application, "at least one" means one or more, and "a plurality of" means two or more. The term "and/or" describes an association relationship between associated objects, and represents that three relationships may exist. For example, A and/or B may represent the following cases: Only A exists, both A and B exist, and only B exists, where A and B may be singular or plural. The character "/" generally indicates an "or" relationship between the associated objects. "At least one of the following items (pieces)" or a similar expression thereof indicates any combination of these items, including a single item (piece) or any combination of a plurality of items (pieces). For example, at least one of a, b, or c may represent: a, b, c, a and b, a and c, b and c, or a, b, and c, where a, b, and c may be singular or plural.

In embodiments of this application, words such as "first" and "second" are used to distinguish between objects with similar names or functions or effect. A person skilled in the art may understand that the words such as "first" and "second" do not limit a quantity and an execution sequence. The term "coupling" is used for representing an electrical connection, including a direct connection through a wire or a connection end or an indirect connection through another device. Therefore, "coupling" should be considered as a generalized electronic communication connection.

It should be noted that in this application, the term such as "example" or "for example" is used to represent giving an example, an illustration, or a description. Any embodiment or design scheme described as an "example" or "for example" in this application should not be explained as being more preferred or having more advantages than another embodiment or design scheme. To be precise, use of the word such as "example" or "for example" is intended to present a relative concept in a specific manner.

Before embodiments of this application are described in the following, an application scenario in this application is first described.

A chiplet (chiplet) is a small chip that has a specific function and can be combined and integrated. The small chip may also be referred to as a die (die), a crystal grain, or a wafer. A chip technology is to integrate a plurality of small chips by using an advanced packaging technology to form a chip of a larger size. The chip may be a system-level chip, for example, the chip may be a system on chip (system on chip, SoC). The foregoing plurality of small chips may use different techniques, have different functions, or even be provided by different suppliers. A plurality of chiplets are integrated by using the chiplet technology to form a large chip, so that design time and costs of the chip can be reduced, performance of the chip can be improved, and a high yield rate can be ensured.

A 2.5D or 3D stacking technology may be used in a process of interconnecting and packaging the plurality of chiplets into the large chip. In the chip based on the chiplet technology, there are usually thousands of interconnected interfaces, and the interface may be used to transmit high-speed data. At present, if a process defect is introduced to an interface of a chiplet during production and manufacturing, a function of the chiplet may be affected, and then a yield rate of an entire packaged chip is affected. Further, if the process defect is not found in a chip test process, a defective chip is used in a product, causing a greater loss. Therefore, an interface test is especially important in terms of test, yield, and costs. The interface test may alternatively be referred to as an input/output (input output, IO) interface (interface) test or an IO test.

When interfaces interconnected between chiplets are tested, a built-in self-test (built-in self-test, BIST) manner may be used, in other words, a transmit end sends a series of test data (or referred to as a sent value), and a receive end receives the test data and compares consistency between the test data and comparison data (or referred to as an expected value) to complete a test. The foregoing test of the interfaces interconnected between the chiplets in the BIST manner may also be referred to as a BIST test. A manner of starting the BIST test is crucial, and synchronous starting of the transmit end and the receive end needs to be implemented, to ensure that the two ends generate a same transmit value and a same expected value at the same time.

In an implementation, synchronous starting of the transmit end and the receive end during the IO test is generally implemented based on a handshake signal. The handshake signal may also be referred to as a data preparation signal or a preparation signal. Specifically, when sending data, the transmit end also sends the preparation signal. The preparation signal is generated by a synchronization circuit in a functional module of the transmit end, and is sent through a specific IO of the functional module. After receiving the preparation signal, the receive end starts the IO test (in other words, starts a data check). In this way, the transmit end and the receive end can synchronously start the IO test based on the preparation signal, thereby ensuring data synchronization between the two ends. Therefore, in the IO test, some key IOs affect the entire test. For example, if the IO through which the preparation signal is transmitted is faulty, synchronous starting of the two ends is affected. Even if an IO can be repaired in the chiplet, a corresponding repair process cannot be executed, thereby affecting a yield rate.

Based on this, an embodiment of this application provides a method for starting an interface test. The interface test may also be referred to as an IOBIST test, in other words, an interface test is performed in a BIST manner. Specifically, in the method, a transmit end may transmit a preamble through at least one of a plurality of interconnected interfaces, and start a BIST test (that is, send test data) after the preamble is completely sent. When receiving and successfully detecting the preamble, a receive end starts a BIST test (that is, starts data receiving and detection), to implement synchronous starting of the transmit end and the receive end. In addition, the method does not depend on synchronization circuits and key IOs of functional modules in the transmit end and the receive end, so that the method is more universal.

Optionally, the method provided in this embodiment of this application may be applied to a chip package including a plurality of chiplets. The plurality of chiplets are interconnected and packaged by using a chiplet technology. The plurality of chiplets include a first chiplet and a second chiplet. The first chiplet and the second chiplet may be used as the transmit end and the receive end. For example, the first chiplet is used as the transmit end and the second chiplet is used as the receive end to perform the method once, and then the second chiplet is used as the transmit end and the first chiplet is used as the receive end to perform the method again.

The technical solutions of this application may be applied to a communication apparatus. The communication apparatus includes a plurality of chiplets, and the plurality of chiplets may be interconnected by using a chiplet technology. Optionally, in the communication apparatus, the plurality of chiplets may be integrated and packaged by using a stacking technology such as 2.5D or 3D. In actual application, the communication apparatus may be a chip (for example, a SoC) or a communication device having a chip. The communication device may be deployed on land, including indoor, outdoor, handheld, or vehicle-mounted. Alternatively, the communication device may be deployed on a water surface (for example, a ship), or may be deployed in the air (for example, on an airplane, a balloon, or a satellite). The communication device may be used in different scenarios.

Optionally, the communication device may include but is not limited to: a mobile phone (mobile phone), a tablet computer, a notebook computer, a palmtop computer, a mobile internet device (mobile internet device, MID), a camera, a wearable device (such as a smart watch, a smart band, or a pedometer), an audio device, an audio and video player, a set-top box, a game console, a printer, a mouse, a keyboard, an in-vehicle device (such as a device on a vehicle, a bicycle, an electric vehicle, an airplane, a ship, a train, or a high-speed railway), a virtual reality (virtual reality, VR) device, an augmented reality (augmented reality, AR) device, a wireless terminal in industrial control (industrial control), a smart home device (such as refrigerator, television, air conditioner, and electric meter), a smart robot, a workshop device, a wireless terminal in self-driving (self-driving), a wireless terminal in remote surgery (remote medical surgery), a wireless terminal in smart grid (smart grid), a wireless terminal in transportation security (transportation safety), a wireless terminal in smart city (smart city), a wireless terminal in smart home (smart home), a flight device (for example, an intelligent robot, a hot air balloon, an unmanned aerial vehicle, or an airplane).

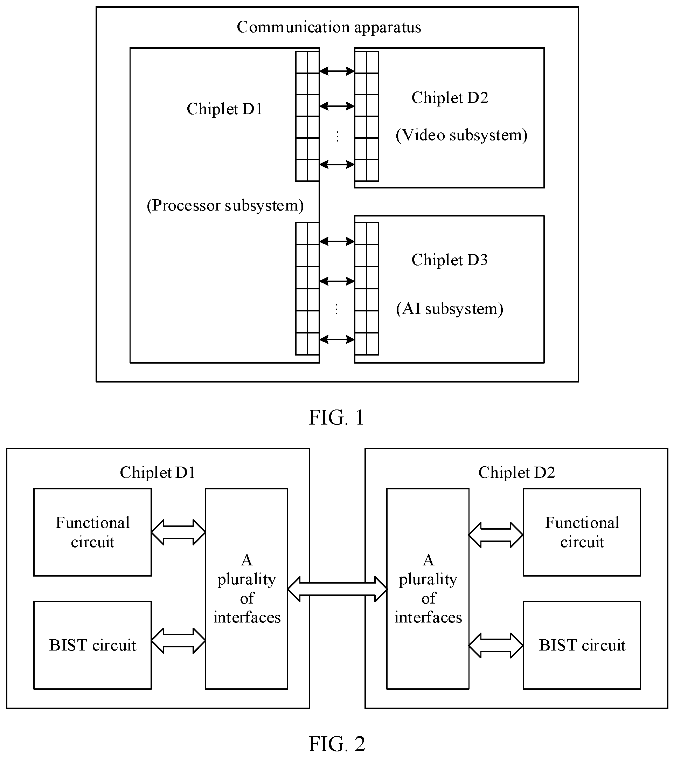

FIG. 1 is a diagram of a structure of a communication apparatus according to an embodiment of this application. The communication apparatus includes a plurality of chiplets, each chiplet may have a plurality of interfaces, any one of the plurality of chiplets may be interconnected to one or more chiplets through the plurality of interfaces, and a same chiplet may be interconnected to different chiplets through different interfaces. In an example, the plurality of chiplets include three chiplets and are represented as D1 to D3, the chiplet D1, the chiplet D2, and the chiplet D3 each have a plurality of interfaces, a part of interfaces of the chiplets D1 are interconnected to the plurality of interfaces of the chiplets D2, and the other part of interfaces of the chiplets D1 are interconnected to the plurality of interfaces of the chiplets D2.

Optionally, the communication apparatus may include a plurality of subsystems with different functions, and each subsystem may be integrated into one of the plurality of chiplets. The plurality of subsystems include but are not limited to a processor subsystem, an audio subsystem, a video subsystem, an artificial intelligence (artificial intelligence, AI) subsystem, an image processing subsystem, a modem (modem) subsystem, or the like. For example, the communication apparatus may include a processor subsystem integrated on the chiplet D1, a video subsystem integrated on the chiplet D2, and an AI subsystem integrated on the chiplet D3.

Each of the foregoing plurality of chiplets may include a functional circuit, a test circuit, and a plurality of interfaces, where the functional circuit and the test circuit are connected to the plurality of interfaces. The functional circuit may be configured to implement a logical function of the chiplet, for example, implement a data processing function or an image processing function. The test circuit may be configured to test the plurality of interfaces. For example, the test circuit may be a BIST circuit. For example, as shown in FIG. 2, for example, the plurality of chiplets include a chiplet D1 and a chiplet D2, each of the chiplet D1 and the chiplet D2 includes a functional circuit, a BIST circuit, and a plurality of interfaces, and the plurality of interfaces of the chiplet D1 are interconnected with the plurality of interfaces of the chiplet D2.

In a possible implementation, the BIST circuit includes a generation circuit and a detection circuit. The generation circuit may be configured to generate related information required for a test. The detection circuit may be configured to detect the related information. For example, the related information may include a preamble, test data, and the like in this embodiment of this application. In a possible example, the BIST circuit may be a linear feedback shift register (linear feedback shift register, LFSR) unit LFSR_UNIT, the generation circuit may be a linear feedback shift register generation circuit LFSR_GEN, and the detection circuit may be a linear feedback shift register detection circuit LFSR_CHK. In other words, LFSR_UNIT may include LFSR_GEN and LFSR_CHK. Further, the test circuit may further include a state machine. The state machine may be configured to switch a state of the test circuit. For example, the state machine may be a finite state machine (finite state machine, FSM). The FSM may switch the state of the test circuit based on a valid (valid) signal that is output by the detection circuit in the test circuit when detection succeeds.

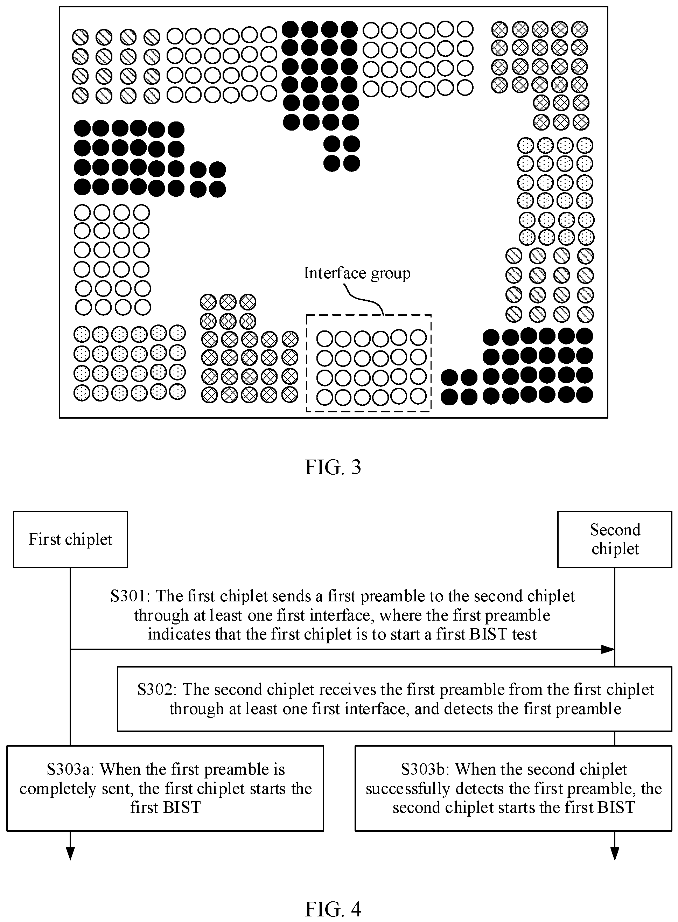

Optionally, a plurality of interfaces of any one of the plurality of chiplets may be divided into different types of interface groups (IO group). In other words, a plurality of interfaces of each chiplet include one or more interface groups, and each interface group may include one or more interfaces. Physical arrangements of different interface groups may be different, and interface groups of a same type may also appear at different locations of a chiplet for a plurality of times. For example, FIG. 3 is a diagram of distribution of interface groups corresponding to a plurality of interfaces of a chiplet. In FIG. 3, interfaces that are located in a same location area and that use a same padding manner belong to a same interface group, interfaces that are located in different location areas and that use different padding manners belong to different interface groups, and a plurality of interface groups of a same type use a same padding manner. The interface group may alternatively be referred to as an IOMACRO or an interface set (which may be represented as IOs).

FIG. 4 is a schematic flowchart of a method for starting an interface test according to an embodiment of this application. The method may be applied to the communication apparatus provided above, and the method includes the following steps.

S301: A first chiplet sends a first preamble to a second chiplet through at least one first interface, where the first preamble indicates that the first chiplet is to start a first BIST test.

The first chiplet may be any one of a plurality of chiplets included in the communication apparatus, the first chiplet may be interconnected to the second chiplet through a plurality of interfaces, and the second chiplet may be any chiplet interconnected to the first chiplet. The plurality of interfaces include the at least one first interface, and the at least one first interface may be any one or more of the plurality of interfaces. For example, the first chiplet may send the first preamble to the second chiplet through a part or all of the plurality of interfaces. Optionally, the plurality of interfaces may be interfaces in one interface group, or may be referred to as interfaces in one IOMACRO.

In addition, the first preamble may be a preamble sent by the first chiplet to the second chiplet. The preamble in this specification may be a data sequence having a specific length, and the data sequence includes different data. The different data may be 0 and 1, in other words, the data in the data sequence cannot be all 0s or all 1s. For example, the data sequence may include a plurality of 0s and a plurality of 1s that are arranged in a specific order. The length of the preamble may be fixed or variable, and a specific value may also be implemented through configuration. For example, the length of the preamble may be 12, 15, 16, or 18. For example, the preamble may be 010110101101100001.

In a possible embodiment, when an interface between the first chiplet and the second chiplet needs to be tested, the first chiplet may send the first preamble to the second chiplet through at least one of the plurality of interfaces interconnected to the second chiplet, in other words, the first chiplet may send the first preamble through each of the at least one interface. That the first preamble indicates that the first chiplet is to start a first BIST test may be understood as that the first chiplet starts the first BIST test after the first preamble is completely sent, for example, starts the first BIST test at a sending end moment of the first preamble. The BIST test may refer to an interface test performed in a BIST manner.

When the at least one first interface includes a plurality of first interfaces, first preambles sent by the first chiplet through the plurality of first interfaces may be the same or different, in other words, first preambles corresponding to different first interfaces may be the same or different. That first preambles corresponding to different first interfaces are different specifically means lengths of the first preambles may be different, or data in the first preambles may be different, or both lengths and data of the first preambles are different. Sending end moments of the corresponding first preambles on the plurality of first interfaces are the same.

Optionally, if the at least one first interface includes the plurality of first interfaces, at least two interfaces between which an interface distance is greater than a preset distance exist in the plurality of first interfaces, that is, a physical distance between the at least two interfaces is long. The preset distance may be preset, and preset distances may be the same or different for different chiplets. This is not specifically limited in embodiments of this application. For example, a quantity of the at least one first interface may be 2, 3, 4, or 5.

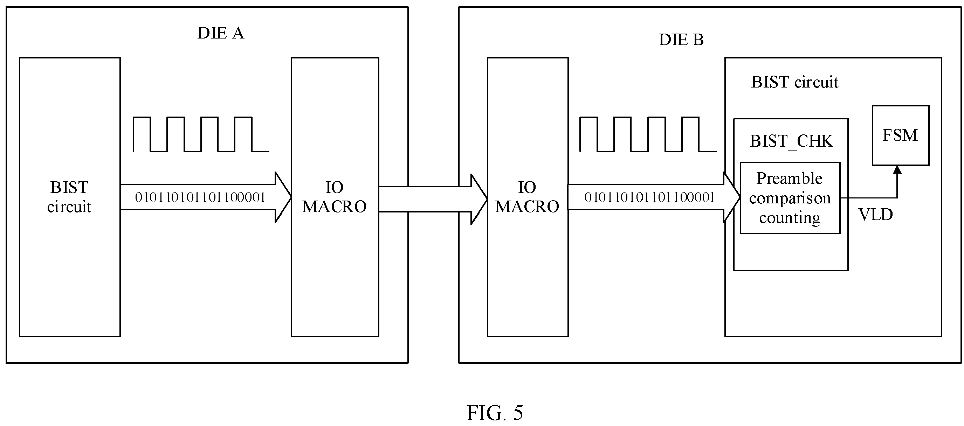

Further, before sending the first preamble, the first chiplet may further generate the first preamble corresponding to the at least one first interface. In an example, as shown in FIG. 5, the first chiplet chip may include a BIST circuit, and the BIST circuit includes a generation circuit. The generation circuit may be configured to generate the first preamble corresponding to the at least one first interface, and send the first preamble to the at least one first interface, so that the corresponding first preamble is transmitted to the second chiplet chip through the at least one first interface. For example, the generation circuit in the BIST circuit is the foregoing linear feedback shift register generation circuit LFSR_GEN. In FIG. 5, the first chiplet is represented as a die A, and the plurality of interfaces of the first chiplet are represented as IOMACRO.

S302: The second chiplet receives the first preamble from the first chiplet through at least one first interface, and detects the first preamble, where the first preamble indicates that the first chiplet is to start the first BIST test.

The second chiplet is interconnected to the plurality of interfaces of the first chiplet through a plurality of interfaces, and the plurality of interfaces of the second chiplet may be interconnected to the plurality of interfaces of the first chiplet in a one-to-one correspondence, so that the at least one first interface used by the second chiplet to receive the first preamble may one-to-one correspond to the at least one first interface used by the first chiplet to send the first preamble. In this specification, the plurality of interfaces of the second chiplet and the plurality of interfaces of the first chiplet may be collectively referred to as a plurality of interfaces, and the first chiplet and the second chiplet may perform sending and receiving through respective interfaces. For brevity of description, in this specification, sending or receiving performed by any chiplet through a respective interface is referred to as sending or receiving performed by any chiplet through an interface.

In a possible embodiment, for a first preamble received through any one of the at least one first interface, that the second chiplet detects the first preamble may include: The second chiplet detects whether the first preamble is consistent with a first comparison preamble, where when the first preamble is consistent with the first comparison preamble, it indicates that the first preamble is successfully detected.

Optionally, while receiving the first preamble, the second chiplet may compare data in the received first preamble with corresponding data in the first comparison preamble, that is, perform bit-by-bit detection on the first preamble and the first comparison preamble. When last data of the first preamble is completely detected and the first preamble is completely consistent with the first comparison preamble, it indicates that the first preamble is successfully detected, or that the first preamble is successfully detected. If the first preamble is inconsistent with the first comparison preamble, it indicates that the first preamble fails to be detected. In this case, the second chiplet may receive and detect the first preamble again.

Further, when the second chiplet receives first preambles from the first chiplet through at least two first interfaces, if the second chiplet successfully detects a first preamble received through any one of the at least two first interfaces, it indicates that the first preamble is successfully detected. In other words, when the first chiplet sends first preambles through the plurality of first interfaces, provided that the second chiplet successfully detects a first preamble received through one of the first interfaces, it indicates that the first preamble is successfully detected, instead of successfully detecting the first preambles received through all the first interfaces. In this way, impact of an interface fault on synchronous starting of the interface test can be effectively reduced.

The first comparison preamble may also be referred to as an expected preamble. Optionally, before comparing the first preamble with the first comparison preamble, the second chiplet may generate a first comparison preamble corresponding to the at least one first interface. In an example, as shown in FIG. 5, the second chiplet may include a BIST circuit. The BIST circuit includes a generation circuit and a detection circuit. The generation circuit may be configured to generate the first comparison preamble corresponding to the at least one first interface. The detection circuit is configured to compare the first preamble with the first comparison preamble, or is used for preamble comparison counting. Further, the BIST circuit further includes a finite state machine FSM that may be configured to receive a valid signal output by the detection circuit, and switch a state of the BIST circuit based on a valid (valid, VLD) signal. In FIG. 5, the second chiplet is represented as a die B, the plurality of interfaces of the second chiplet are represented as IOMACRO, the detection circuit in the BIST circuit of the chiplet die B is represented as BIST_CHK, and the valid signal output by BIST_CHK is represented as VLD.

Related descriptions of the first comparison preamble used during comparison of the second chiplet are consistent with the foregoing related descriptions of the first preamble sent by the first chiplet. In addition, a process in which the second chiplet generates the first comparison preamble corresponding to the at least one first interface may be consistent with a process in which the first chiplet generates the first preamble corresponding to the at least one first interface. Details are not described in embodiments of this application.

S303a: When the first preamble is completely sent, the first chiplet starts the first BIST test. S303b: When the second chiplet successfully detects the first preamble, the second chiplet starts the first BIST test.

That the first chiplet starts the first BIST test may mean that the first chiplet sends test data to the second chiplet, or is referred to as that the first chiplet is in a test sending state. That the second chiplet starts the first BIST test may mean that the second chiplet receives and detects the test data sent by the first chiplet, or is referred to as that the second chiplet is in a test receiving state.

In a possible embodiment, the first chiplet starts the first BIST test when the first preamble is completely sent, and the second chiplet starts the first BIST test when successfully detecting the first preamble, so that the first chiplet and the second chiplet can simultaneously start the first BIST test, thereby implementing testing on the plurality of interfaces in a direction from the first chiplet to the second chiplet.

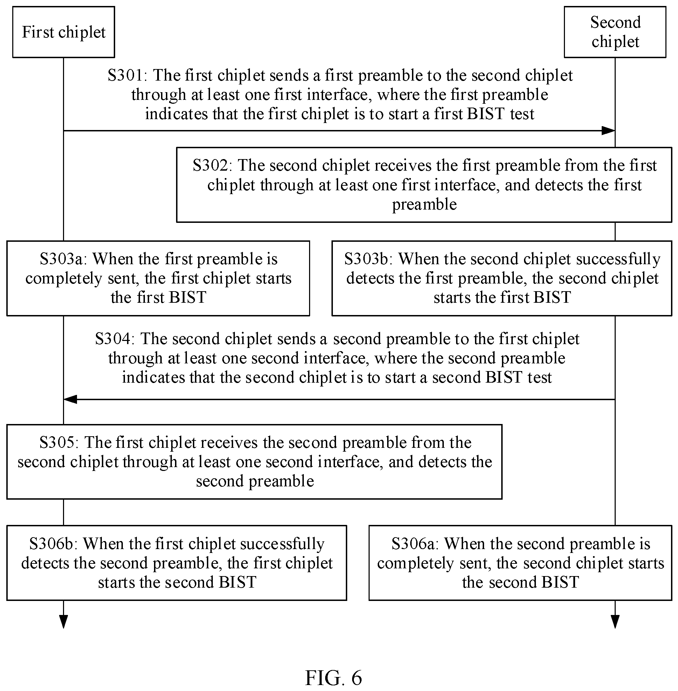

Further, after the first chiplet and the second chiplet complete the first BIST test, the second chiplet and the first chiplet may further complete a second BIST test in a similar manner. In the first BIST test, the first chiplet is used as a transmit end and the second chiplet is used as a receive end, and in the second BIST test, the second chiplet is used as a transmit end and the first chiplet is used as a receive end. In an entire process including the first BIST test and the second BIST test, which one of the first chiplet and the second chiplet is used as the transmit end or the receive end may be preset, or may be selected by a user when the test starts. This is not specifically limited in embodiments of this application. For example, as shown in FIG. 6, the method further includes S304 and S306b.

S304: The second chiplet sends a second preamble to the first chiplet through at least one second interface, where the second preamble indicates that the second chiplet is to start a second BIST test.

The second preamble may be a preamble sent by the second chiplet to the first chiplet. The second preamble and the first preamble may be a same preamble. For detailed descriptions of the second preamble, refer to the foregoing related descriptions of the first preamble. Details are not described herein again in embodiments of this application. In addition, the at least one second interface may be a part of the plurality of interfaces of the second chiplet, and the at least one second interface may be the same as or different from the at least one first interface. This is not specifically limited in embodiments of this application.

In a possible embodiment, the second chiplet may send the second preamble to the first chiplet through at least one of the plurality of interfaces interconnected to the first chiplet, that is, the second chiplet may send the second preamble through each of the at least one interface. That the second preamble indicates that the second chiplet is to start a second BIST test may be understood as that the second chiplet starts the second BIST test after the second preamble is completely sent, for example, starts the second BIST test at a sending end moment of the second preamble.

When the at least one second interface includes a plurality of second interfaces, second preambles sent by the second chiplet through the plurality of second interfaces may be the same or different, that is, second preambles corresponding to different second interfaces may be the same or different. Sending end moments of the corresponding second preambles on the plurality of second interfaces are the same. Optionally, if the at least one second interface includes the plurality of second interfaces, at least two interfaces between which an interface distance is greater than a preset distance exist in the plurality of second interfaces.

Further, before sending the second preamble, the second chiplet may further generate the second preamble corresponding to the at least one second interface. In an example, in the second chiplet, the generation circuit of the BIST circuit may be configured to: generate the second preamble corresponding to the at least one second interface, and send the second preamble to the at least one second interface, so that the corresponding second preamble is transmitted to the first chiplet through the at least one second interface.

S305: The first chiplet receives the second preamble from the second chiplet through the at least one second interface, and detects the second preamble, where the second preamble indicates that the second chiplet is to start the second BIST test.

In a possible embodiment, for a second preamble received through any second interface of the at least one second interface, that the first chiplet detects the second preamble may include: The first chiplet detects whether the second preamble is consistent with a second comparison preamble, and when the second preamble is consistent with the second comparison preamble, it indicates that the second preamble is successfully detected.

Optionally, while receiving the second preamble, the first chiplet may compare data in the received second preamble with corresponding data in the second comparison preamble, that is, perform bit-by-bit detection on the second preamble and the second comparison preamble. When last data of the second preamble is completely detected and the second preamble is completely consistent with the second comparison preamble, it indicates that the second preamble is successfully detected, or that the second preamble is successfully detected. If the second preamble is inconsistent with the second comparison preamble, it indicates that the second preamble fails to be detected. In this case, the first chiplet may receive and detect the second preamble again.

Further, when the first chiplet receives second preambles from the second chiplet through at least two second interfaces, if the first chiplet successfully detects a second preamble received through any one of the at least two second interfaces, it indicates that the second preamble is successfully detected. In other words, when the second chiplet sends second preambles through the plurality of second interfaces, provided that the first chiplet successfully detects a second preamble received through one of the second interfaces, it indicates that the second preamble is successfully detected, instead of successfully detecting the second preambles received through all the second interfaces. In this way, impact of an interface fault on synchronous starting of the interface test can be effectively reduced.

The second comparison preamble may also be referred to as an expected preamble. Optionally, before comparing the second preamble with the second comparison preamble, the first chiplet may generate a second comparison preamble corresponding to the at least one second interface. In an example, the BIST circuit in the first chiplet includes a generation circuit and a detection circuit. The generation circuit may be configured to generate the second comparison preamble corresponding to the at least one second interface. The detection circuit is configured to compare the second preamble with the second comparison preamble.

Related descriptions of the second comparison preamble used during comparison of the first chiplet are consistent with the foregoing related descriptions of the second preamble sent by the second chiplet. In addition, a process in which the first chiplet generates the second comparison preamble corresponding to the at least one second interface may be consistent with a process in which the second chiplet generates the second preamble corresponding to the at least one second interface. Details are not described in embodiments of this application.

S306a: When the second preamble is completely sent, the second chiplet starts the second BIST test. S306b: When the first chiplet successfully detects the second preamble, the first chiplet starts the second BIST test.

That the second chiplet starts the second BIST test may mean that the second chiplet sends test data to the first chiplet, or is referred to as that the second chiplet is in a test sending state. That the first chiplet starts the second BIST test may mean that the first chiplet receives and detects the test data sent by the second chiplet, or is referred to as that the first chiplet is in a test receiving state.

In a possible embodiment, the second chiplet starts the second BIST test when the first preamble is completely sent, and the first chiplet starts the second BIST test when successfully detecting the second preamble, so that the first chiplet and the second chiplet can simultaneously start the second BIST test, thereby implementing testing on the plurality of interfaces in a direction from the second chiplet to the first chiplet.

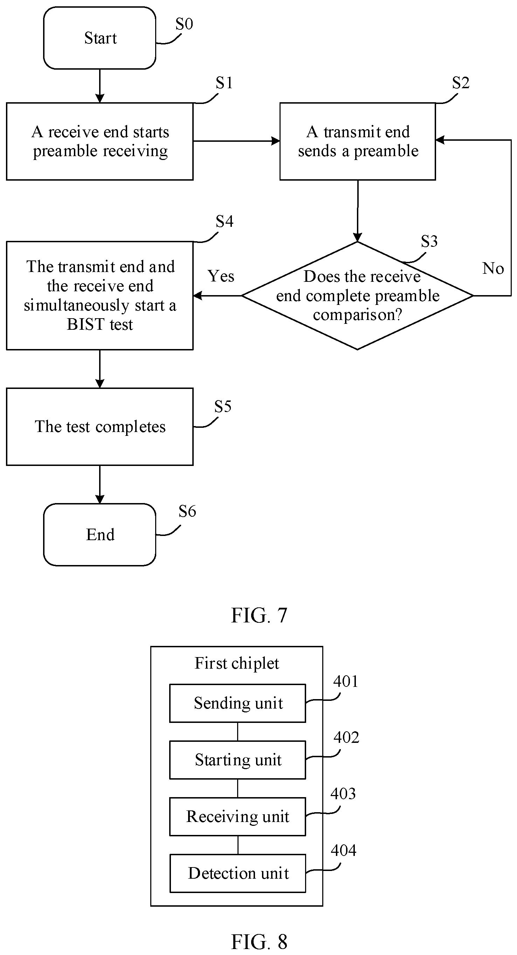

For ease of understanding, the following describes a related procedure for starting the interface test in this embodiment of this application by using an example. When the first chiplet and the second chiplet (that is, two end dies) start an IOBIST test, one end is first selected as a transmit end, and the other end is selected as a receive end (for example, the first chiplet is the transmit end, and the second chiplet is the receive end), and then the following process is performed: The receive end is first started, to wait to receive a preamble; and the transmit end is started, to send a string of preambles to the receive end, where the preamble indicates that the transmit end is to start the BIST test; the receive end observes the preamble in real time, and after the string of preambles is completely compared, the two ends synchronously start the BIST test, and complete the BIST test; and then directions of the two ends are reversed (for example, the first chiplet is the receive end, and the second chiplet is the transmit end), and the foregoing steps are repeated. If both a forward test and a reverse test are completed, the test ends. As shown in FIG. 7, a corresponding procedure includes: S0. Start; S1. A receive end starts preamble receiving; S2. A transmit end sends a preamble; S3. Determine whether the receive end completes preamble comparison, and if yes, perform S4; if no, return to S2; S4. The transmit end and the receive end simultaneously start a BIST test; S5. The test completes, that is, a forward test and a reverse test are completed; and S6. End.

In this embodiment of this application, the transmit end in the first chiplet and the second chiplet may transmit the preamble through at least one of the plurality of interconnected interfaces, and start the BIST test (that is, send test data) after the preamble is completely sent. The receive end may start the BIST test when receiving and successfully detecting the preamble, so that the transmit end and the receive end perform synchronous starting, thereby ensuring validity of the BIST test. The method does not depend on synchronization circuits and key IOs of functional modules in the transmit end and the receive end, so that the method is more universal.

In a possible embodiment of this application, a method for starting an interface test includes: A first chiplet sends a first preamble to a second chiplet through at least one first interface, where the first preamble indicates that the first chiplet is to start a first BIST test, the first chiplet is interconnected to the second chiplet through a plurality of interfaces, and the plurality of interfaces include the at least two first interfaces; and when the first preamble is completely sent, the first chiplet starts the first BIST test.

In a possible embodiment of this application, a method for starting an interface test includes: A first chiplet sends first preambles to a second chiplet through at least two first interfaces, where the first preamble indicates that the first chiplet is to start a first BIST test, the first chiplet is interconnected to the second chiplet through a plurality of interfaces, and the plurality of interfaces include the at least two first interfaces; and when the first preamble is completely sent, the first chiplet starts the first BIST test. Optionally, interfaces between which an interface distance is greater than a preset distance exists in the at least two first interfaces.

In a possible embodiment of this application, a method for starting an interface test includes: A first chiplet receives a second preamble from a second chiplet through at least one second interface, and detects the second preamble, where the second preamble indicates that the second chiplet is to start a second BIST test, the first chiplet is interconnected to the second chiplet through a plurality of interfaces, and the plurality of interfaces include the at least two first interfaces; and when the first chiplet successfully detects the second preamble, the first chiplet starts the second BIST test.

In a possible embodiment of this application, a method for starting an interface test includes: A first chiplet receives a second preamble from a second chiplet through at least one second interface, where the second preamble indicates that the second chiplet is to start a second BIST test, the first chiplet is interconnected to the second chiplet through a plurality of interfaces, and the plurality of interfaces include the at least two first interfaces; for a second preamble corresponding to any one of the at least one second interface, the first chiplet detects whether the second preamble is consistent with a comparison preamble, and when the second preamble is consistent with the comparison preamble, it indicates that the second preamble is successfully detected; and when the first chiplet successfully detects the second preamble, the first chiplet starts the second BIST test.

In a possible embodiment of this application, a method for starting an interface test includes: A first chiplet receives a second preamble from a second chiplet through at least two second interfaces, where the second preamble indicates that the second chiplet is to start a second BIST test, the first chiplet is interconnected to the second chiplet through a plurality of interfaces, and the plurality of interfaces include the at least two first interfaces; for a second preamble corresponding to any one of the at least two second interfaces, the first chiplet detects whether the second preamble is consistent with a comparison preamble, and when the second preamble is consistent with the comparison preamble, it indicates that the second preamble is successfully detected; and when the first chiplet successfully detects the second preamble, the first chiplet starts the second BIST test. Optionally, interfaces between which an interface distance is greater than a preset distance exists in the at least two second interfaces.

In a possible embodiment of this application, a method for starting an interface test includes: A second chiplet receives a first preamble from a first chiplet through at least one first interface, and detects the first preamble, where the first preamble indicates that the first chiplet is to start a first BIST test, the second chiplet is interconnected to the first chiplet through a plurality of interfaces, and the plurality of interfaces include the at least two first interfaces; and when the second chiplet successfully detects the first preamble, the second chiplet starts the first BIST test.

In a possible embodiment of this application, a method for starting an interface test includes: A second chiplet receives a first preamble from a first chiplet through at least one first interface, where the first preamble indicates that the first chiplet is to start a first BIST test, the second chiplet is interconnected to the first chiplet through a plurality of interfaces, and the plurality of interfaces include the at least two first interfaces; for a first preamble corresponding to any one of the at least one first interface, the second chiplet detects whether the first preamble is consistent with a comparison preamble, and when the first preamble is consistent with the comparison preamble, it indicates that the first preamble is successfully detected; and when the second chiplet successfully detects the second preamble, the second chiplet starts the first BIST test.

In a possible embodiment of this application, a method for starting an interface test includes: A second chiplet receives a first preamble from a first chiplet through at least two first interfaces, where the first preamble indicates that the first chiplet is to start a first BIST test, the second chiplet is interconnected to the first chiplet through a plurality of interfaces, and the plurality of interfaces include the at least two first interfaces; for a first preamble corresponding to any one of the at least two first interfaces, the second chiplet detects whether the first preamble is consistent with a comparison preamble, and when the first preamble is consistent with the comparison preamble, it indicates that the first preamble is successfully detected; and when the second chiplet successfully detects the second preamble, the second chiplet starts the first BIST test. Optionally, interfaces between which an interface distance is greater than a preset distance exists in the at least two first interfaces.

In a possible embodiment of this application, a method for starting an interface test includes: A second chiplet sends a second preamble to a first chiplet through at least one second interface, where the second preamble indicates that the second chiplet is to start a second BIST test, the second chiplet is interconnected to the first chiplet through a plurality of interfaces, and the plurality of interfaces include the at least two first interfaces; and when the second preamble is completely sent, the second chiplet starts the second BIST test.

In a possible embodiment of this application, a method for starting an interface test includes: A second chiplet sends a second preamble to a first chiplet through at least two second interfaces, where the second preamble indicates that the second chiplet is to start a second BIST test, the second chiplet is interconnected to the first chiplet through a plurality of interfaces, and the plurality of interfaces include the at least two first interfaces; and when the second preamble is completely sent, the second chiplet starts the second BIST test. Optionally, interfaces between which an interface distance is greater than a preset distance exists in the at least two second interfaces.

In a possible embodiment of this application, a synchronization solution is provided. The synchronization solution may include a preamble solution, and may be applied to the chiplet die A and the chiplet die B shown in FIG. 5 above. The IOBIST test involves alignment of test data of the transmit end die and comparison data at the receive end. To implement data synchronization in the two end dies, synchronous starting of IOBIST circuits (or referred to as BIST circuits) at the two ends needs to be considered. To synchronously generate, at the receive end, an expected value that is the same as that output by the transmit end, a handshake signal needs to exist at the two ends, so that the receive end observes a sent signal in real time, and determines start time based on the received signal.

To implement synchronous starting of the two ends, the preamble is introduced. In other words, before the test data is sent, a string of data is sent to the receive end. After the receive end continuously compares the preamble, a BIST check is started at the receive end. In this way, synchronous starting of the BIST circuits at the two ends is completed.

A test procedure in an asynchronous scenario is described. A specific process of the asynchronous starting scenario is as follows: (a) When two end dies start an IOBIST test, one end is first selected as a transmit end, and the other end is selected as a receive end; (b) The receive end is started first, to wait to receive a preamble; (c) The transmit end is started, to send a string of preambles to the receive end, to indicate that the transmit end is to start a BIST test; (d) The receive end observes the preamble in real time, and after the string of preambles is compared, the two ends synchronously start the BIST test, and complete the BIST test; and (e) Directions of the two ends are reversed, to repeat steps (b) to (d). If both a forward test and a reverse test are complete, the test ends. For a process of synchronous starting at the two ends, refer to FIG. 7.

The foregoing mainly describes the solutions provided in embodiments of this application from a perspective of interaction between the first chiplet and the first chiplet. It may be understood that to implement the foregoing functions, the first chiplet and the first chiplet include corresponding hardware structures and/or software modules for performing the functions. A person skilled in the art should easily be aware that, in combination with units and algorithm steps of the examples described in embodiments disclosed in this specification, this application may be implemented by hardware or a combination of hardware and computer software. Whether a function is performed by hardware or hardware driven by computer software depends on particular applications and design constraints of the technical solutions. A person skilled in the art may use different methods to implement the described functions for each particular application, but it should not be considered that the implementation goes beyond the scope of this application.

In embodiments of this application, the first chiplet and the first chiplet may be divided into functional modules based on the foregoing method examples. For example, the functional modules may be obtained through division based on corresponding functions, or two or more functions may be integrated into one processing module. The integrated module may be implemented in a form of hardware, or may be implemented in a form of a software functional module. It should be noted that, in embodiments of this application, module division is an example, and is merely a logical function division. In actual implementation, another division manner may be used. Descriptions are provided below by using an example in which each functional module is obtained through division based on each corresponding function.

When an integrated unit is used, FIG. 8 is a diagram of a structure of an apparatus for starting an interface test according to the foregoing embodiment. The apparatus may be a first chiplet, and the apparatus includes a sending unit 401 and a starting unit 402. The sending unit 401 may be configured to support the apparatus in performing S301 in the foregoing method embodiment. The starting unit 402 is configured to support the apparatus in performing S303a in the foregoing method embodiment. Further, the apparatus further includes a receiving unit 403 and a detection unit 404. The receiving unit 403 is configured to support the apparatus in performing the receiving step in S305 in the foregoing method embodiment. The detection unit 404 is configured to support the apparatus in performing the detection step in S305 in the foregoing method embodiment. The starting unit 402 is configured to support the apparatus in performing S306b in the foregoing method embodiment. All related content of each step involved in the foregoing method embodiment may be referenced to a function description of a corresponding functional module, and details are not described herein again in embodiments of this application.

Based on hardware implementation, in this embodiment of this application, the starting unit 402 and the detection unit 404 may be a processor of the apparatus, the sending unit 401 may be a transmitter of the apparatus, the receiving unit 403 may be a receiver of the apparatus, the transmitter and the receiver may be usually integrated together to serve as a transceiver, and a specific transceiver may also be referred to as a communication interface or an interface circuit.

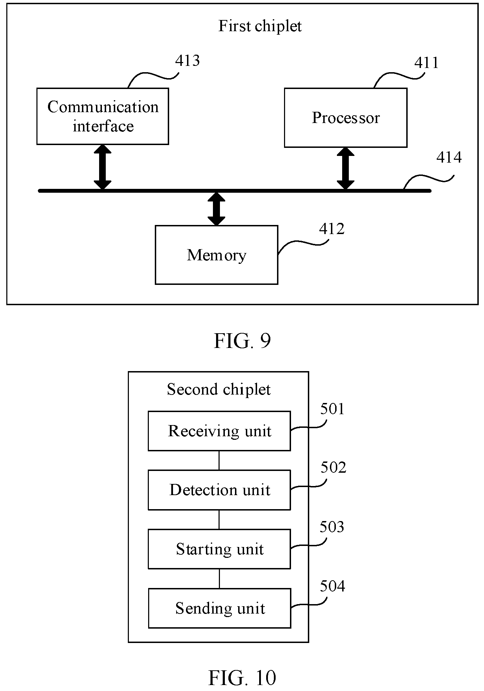

FIG. 9 is a diagram of a structure of another apparatus for starting an interface test in the foregoing embodiment according to an embodiment of this application. The apparatus may be used as a first chiplet. The apparatus includes a processor 411, and may further include a memory 412, a communication interface 413, and a bus 414. The processor 411, the memory 412, and the communication interface 413 are connected through the bus 414.

The processor 411 is configured to control and manage an action of the apparatus. In a possible embodiment, the processor 411 may be configured to support the apparatus in receiving S303a and S306b in the foregoing method embodiment, and/or another technical process described in this specification. The communication interface 413 is configured to support the apparatus in communicating, for example, support the apparatus in communicating with a second chiplet.

In this embodiment of this application, the processor 411 may be a central processing unit, a general-purpose processor, a digital signal processor, an application-specific integrated circuit, a field programmable gate array or another programmable logic device, a transistor logical device, a hardware component, or any combination thereof. The processor may implement or execute various example logical blocks, modules, and circuits described with reference to content disclosed in this application. Alternatively, the processor may be a combination of processors implementing a computing function, for example, a combination of one or more microprocessors, or a combination of the digital signal processor and a microprocessor. The bus 414 may include an address bus, a data bus, a control bus, and the like.

When an integrated unit is used, FIG. 10 is a diagram of a structure of an apparatus for starting an interface test according to the foregoing embodiment. The apparatus may be a second chiplet, and the apparatus includes a receiving unit 501, a detection unit 502, and a starting unit 503. The receiving unit 501 may be configured to support the apparatus in performing the receiving step in S302 in the foregoing method embodiment. The detection unit 502 may be configured to support the apparatus in performing the detection step in S302 in the foregoing method embodiment. The starting unit 503 is configured to support the apparatus in performing S303b in the foregoing method embodiment. Further, the apparatus further includes a sending unit 504. The sending unit 504 may be configured to support the apparatus in performing S304 in the foregoing method embodiment. The starting unit 503 is further configured to support the apparatus in performing S306a in the foregoing method embodiment. All related content of each step involved in the foregoing method embodiment may be referenced to a function description of a corresponding functional module, and details are not described herein again in embodiments of this application. All related content of each step involved in the foregoing method embodiment may be referenced to a function description of a corresponding functional module, and details are not described herein again in embodiments of this application.

Based on hardware implementation, in this embodiment of this application, the detection unit 502 and the starting unit 503 may be a processor of the apparatus, the receiving unit 501 may be a receiver of the apparatus, the sending unit 504 may be a transmitter of the apparatus, the transmitter and the receiver may be usually integrated together to serve as a transceiver, and a specific transceiver may also be referred to as a communication interface or an interface circuit.

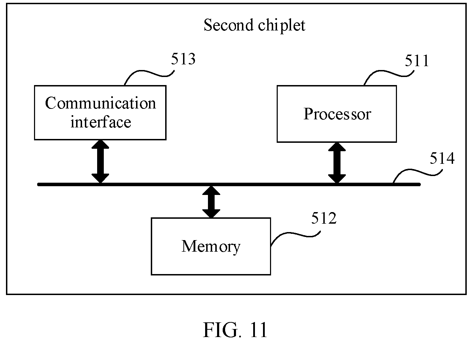

FIG. 11 is a diagram of a structure of another apparatus for starting an interface test in the foregoing embodiment according to an embodiment of this application. The apparatus may be used as a second chiplet. The apparatus includes a processor 511, and may further include a memory 512, a communication interface 513, and a bus 514. The processor 511, the memory 512, and the communication interface 513 are connected through the bus 514.

The processor 511 is configured to control and manage an action of the apparatus. In a possible embodiment, the processor 511 may be configured to support the apparatus in performing the detection step in S302, S303b, and S306a in the foregoing method embodiment, and/or another technical process described in this specification. The communication interface 513 is configured to support the apparatus in communicating, for example, support the apparatus in communicating with a first chiplet.

In this embodiment of this application, the processor 511 may be a central processing unit, a general-purpose processor, a digital signal processor, an application-specific integrated circuit, a field programmable gate array or another programmable logic device, a transistor logical device, a hardware component, or any combination thereof. The processor may implement or execute various example logical blocks, modules, and circuits described with reference to content disclosed in this application. Alternatively, the processor may be a combination of processors implementing a computing function, for example, a combination of one or more microprocessors, or a combination of the digital signal processor and a microprocessor. The bus 514 may include an address bus, a data bus, a control bus, and the like.

In another embodiment of this application, a communication apparatus is provided. The communication apparatus includes a first chiplet and a second chiplet. The first chiplet may be or include the apparatus provided in FIG. 8 or FIG. 9, and is configured to perform the steps of the first chiplet in the method embodiment provided above. The second chiplet may be or include the apparatus provided in FIG. 10 or FIG. 11, and is configured to perform the steps of the second chiplet in the method embodiment provided above.

It may be understood that all related content of the steps in the foregoing method embodiments may be referenced to embodiments of the apparatus for starting an interface test and the communication apparatus. Details are not described in this embodiment of this application again.

In the several embodiments provided in this application, it should be understood that the disclosed apparatus and method may be implemented in other manners. For example, the described apparatus embodiment is merely an example. For example, the module or division into the units is merely logical function division and may be other division in actual implementation. For example, a plurality of units or components may be combined or integrated into another apparatus, or some features may be ignored or not performed.

The units described as separate parts may or may not be physically separate, and parts displayed as units may be one or more physical units, may be located in one place, or may be distributed on different places. Some or all of the units may be selected based on actual requirements to achieve the objectives of the solutions of embodiments.

If the integrated unit is implemented in a form of a software functional unit and is sold or used as an independent product, the integrated unit may be stored in a readable storage medium. The readable storage medium may include any medium that can store program code, for example, a USB flash drive, a removable hard disk, a read-only memory, a random access memory, a magnetic disk, or an optical disc. Based on such an understanding, the technical solutions in embodiments of this application essentially, or the part contributing to the current technology, or all or some of the technical solutions may be embodied in a form of a software product.

In another embodiment of this application, a readable storage medium is further provided. The readable storage medium stores computer-executable instructions. When a device (which may be a single-chip microcomputer, a chip, or the like) or a processor performs the steps of the first chiplet in the foregoing method embodiment.

In another embodiment of this application, a readable storage medium is further provided. The readable storage medium stores computer-executable instructions. When a device (which may be a single-chip microcomputer, a chip, or the like) or a processor performs the steps of the second chiplet in the foregoing method embodiment.

In still another embodiment of this application, a computer program product is further provided. The computer program product includes computer instructions, and the computer instructions are stored in a readable storage medium. At least one processor of a device may read the computer instructions from the readable storage medium, and the at least one processor executes the computer instructions to enable the device to perform the steps of the first chiplet in the foregoing method embodiment.

In another embodiment of this application, a computer program product is further provided. The computer program product includes computer instructions, and the computer instructions are stored in a readable storage medium. At least one processor of a device may read the computer instructions from the readable storage medium, and the at least one processor executes the computer instructions to enable the device to perform the steps of the second chiplet in the foregoing method embodiment.

In conclusion, the foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A method for starting an interface test, wherein the method comprises:
sending, by a first chiplet, a first preamble to a second chiplet through at least one first interface, wherein the first preamble indicates that the first chiplet is to start a first built-in self-test, BIST, test, the first chiplet is interconnected to the second chiplet through a plurality of interfaces, and the plurality of interfaces comprise the at least one first interface; and
when the first preamble is completely sent, starting, by the first chiplet, the first BIST test.

2. The method according to claim 1, wherein the at least one first interface comprises at least two first interfaces, and the sending, by a first chiplet, a first preamble to a second chiplet through at least one first interface comprises: sending, by the first chiplet, the first preamble to the second chiplet through each of the at least two first interfaces.

3. The method according to claim 1 or 2, wherein the method further comprises:
receiving, by the first chiplet, a second preamble from the second chiplet through at least one second interface, and detecting the second preamble, wherein the second preamble indicates that the second chiplet is to start a second BIST test; and
when the first chiplet successfully detects the second preamble, starting, by the first chiplet, the second BIST test.

4. The method according to claim 3, wherein the at least one second interface comprises at least two second interfaces, and the receiving, by the first chiplet, a second preamble from the second chiplet through at least one second interface comprises: receiving, by the first chiplet, the second preamble from the second chiplet through each of the at least two second interfaces.

5. The method according to claim 3 or 4, wherein for a second preamble corresponding to any one of the at least one second interface, the method further comprises: detecting, by the first chiplet, whether the second preamble is consistent with a comparison preamble, wherein when the second preamble is consistent with the comparison preamble, it indicates that the second preamble is successfully detected.

6. The method according to any one of claims 1 to 5, applied to a chip package comprising a plurality of chiplets, wherein the plurality of chiplets are interconnected and packaged by using a chiplet technology, and the plurality of chiplets comprise the first chiplet and the second chiplet.

7. The method according to any one of claims 1 to 6, wherein the first preamble or the second preamble comprises a plurality of pieces of data of specific lengths, and there is different data in the plurality of pieces of data.

8. A method for starting an interface test, wherein the method comprises:
receiving, by a second chiplet, a first preamble from a first chiplet through at least one first interface, and detecting the first preamble, wherein the first preamble indicates that the first chiplet is to start a first built-in self-test, BIST, test, the second chiplet is interconnected to the first chiplet through a plurality of interfaces, and the plurality of interfaces comprise the at least one first interface; and
when the second chiplet successfully detects the first preamble, starting, by the second chiplet, the first BIST test.

9. The method according to claim 8, wherein the at least one first interface comprises at least two first interfaces, and the receiving, by a second chiplet, a first preamble from a first chiplet through at least one first interface comprises: receiving, by the second chiplet, the first preamble from the first chiplet through each of the at least two first interfaces.

10. The method according to claim 8 or 9, wherein for a first preamble corresponding to any one of the at least one first interface, the detecting, by a second chiplet, the first preamble comprises: detecting, by the second chiplet, whether the first preamble is consistent with a comparison preamble, wherein when the first preamble is consistent with the comparison preamble, it indicates that the first preamble is successfully detected.

11. The method according to any one of claims 8 to 10, wherein the method further comprises:
sending, by the second chiplet, a second preamble to the first chiplet through at least one second interface, wherein the second preamble indicates that the second chiplet is to start a second BIST test; and
when the second preamble is completely sent, starting, by the second chiplet, the second BIST test.

12. The method according to claim 11, wherein the at least one second interface comprises at least two second interfaces, and the sending, by the second chiplet, a second preamble to the first chiplet through at least one second interface comprises: sending, by the second chiplet, the second preamble to the first chiplet through each of the at least two second interfaces.

13. The method according to any one of claims 8 to 12, applied to a chip package comprising a plurality of chiplets, wherein the plurality of chiplets are interconnected and packaged by using a chiplet technology, and the plurality of chiplets comprise the first chiplet and the second chiplet.

14. An apparatus for starting an interface test, wherein the apparatus comprises a processing circuit and a communication interface, and the processing circuit and the communication interface are configured to support the apparatus in performing the method according to any one of claims 1 to 7.

15. An apparatus for starting an interface test, wherein the apparatus comprises a processing circuit and a communication interface, and the processing circuit and the communication interface are configured to support the apparatus in performing the method according to any one of claims 8 to 13.
